(19) Europäisches Patentamt
European Patent Office
Office européen des brevets

(11) **EP 3 420 369 B1**

(12) **EUROPÄISCHE PATENTSCHRIFT**

(45) Veröffentlichungstag und Bekanntmachung des Hinweises auf die Patenterteilung:
**29.12.2021 Patentblatt 2021/52**

(21) Anmeldenummer: **17709919.9**

(22) Anmeldetag: **20.02.2017**

(51) Int Cl.:
**G01R 27/26** (2006.01)  **G01R 35/00** (2006.01)
**G01D 5/20** (2006.01)  **G01D 18/00** (2006.01)

(86) Internationale Anmeldenummer:
**PCT/EP2017/053797**

(87) Internationale Veröffentlichungsnummer:
**WO 2017/144414 (31.08.2017 Gazette 2017/35)**

(54) **VERFAHREN UND VORRICHTUNG ZUM MESSEN ZUMINDEST EINER EIGENSCHAFT EINER SPULE, VERFAHREN UND VORRICHTUNG ZUM MESSEN DER POSITION EINES BETÄTIGUNGSGLIEDS, SOWIE KRAFTFAHRZEUG**

METHOD AND DEVICE FOR MEASURING AT LEAST ONE PROPERTY OF A COIL, METHOD AND DEVICE FOR MEASURING THE POSITION OF AN ACTUATION MEMBER, AND MOTOR VEHICLE

PROCÉDÉ ET DISPOSITIF DE MESURE D'AU MOINS UNE PROPRIÉTÉ D'UNE BOBINE, PROCÉDÉ ET DISPOSITIF DE MESURE DE LA POSITION D'UN ÉLÉMENT D'ACTIONNEMENT, ET VÉHICULE À MOTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.02.2016 DE 102016103075**

(43) Veröffentlichungstag der Anmeldung:
**02.01.2019 Patentblatt 2019/01**

(73) Patentinhaber: **KNORR-BREMSE Systeme für Nutzfahrzeuge GmbH**
**80809 München (DE)**

(72) Erfinder: **EISSNER, Markus**
**92676 Eschenbach (DE)**

(56) Entgegenhaltungen:
WO-A1-2013/110145   DE-A1-102005 034 859
DE-A1-102008 042 095   FR-A1- 2 565 695
US-A- 4 103 233   US-A1- 2015 300 843

EP 3 420 369 B1

**Beschreibung**

GEBIET DER ERFINDUNG

Die Erfindung betrifft ein Verfahren und eine Vorrichtung zum Messen zumindest einer Eigenschaft einer Spule, vorzugsweise einer bei Messungen anderer Größen eingesetzten Messspule, wie etwa einer Spule, in die ein Betätigungsglied an beispielsweise einem Pedal in einem Kraftfahrzeug eintaucht oder über die sich ein solches Betätigungsglied schiebt. Entsprechend betrifft die Erfindung auch ein Verfahren und eine Vorrichtung zum Messen einer Position eines solchen Betätigungsglieds. Schließlich betrifft die Vorrichtung auch noch ein Kraftfahrzeug mit einem ein Betätigungsglied aufweisenden Betätigungselement.

HINTERGRUND DER ERFINDUNG

Es ist prinzipiell bekannt, beispielsweise aus der US 6 469 500 B1, die Stellung und ggf. die Geschwindigkeit eines Betätigungsglieds, das vor- und zurückbewegbar ist mit Hilfe einer Spule zu ermitteln, in die dieses Betätigungsglied eintaucht. In dem Falle der US 6 469 500 B1 weist das Betätigungsglied einen Permanentmagneten auf. Eine Änderung in der Impedanz der Spule oder des durch die Spule fließenden Stromes werden als Signal zur Erfassung der Stellung des Betätigungsglieds erfasst.

Für derartige Wegsensoren ist es aus der US 7 053 603 B2 bekannt, auch eine Temperaturabhängigkeit des Ohmschen Widerstandes der Spule zu erfassen und zu berücksichtigen.

Die DE 10 2010 036 126 B3 offenbart allgemein ein Verfahren zum Bestimmen mindestens eines Kennwertes für eine Spulenkenngröße einer Mikrospule, wobei die Mikrospule mit einer entsprechenden Messeinrichtung nicht verdrahtet wird. Es werden Frequenzen durchgefahren, hierbei der Frequenzgang für eine Antenneneingangsimpedanz gemessen und mit einem durch ein analytisches Modell für die Mikrospule ermittelten Frequenzgang verglichen.

Spulen, in welche Betätigungsglieder beispielsweise an einem Pedal in einem Kraftfahrzeug eintauchen oder über die sich solche Betätigungsglieder schieben, werden herkömmlicherweise wasserdicht versiegelt, um das Eintreten von Wasser zu vermeiden. Wasser kann den Wert der Kapazität der Spule beträchtlich ändern und so Messergebnisse verfälschen. Das Versiegeln solcher Spulen ist sehr aufwändig und teuer. Es wird ein Weg gesucht, um auf ein solches Versiegeln verzichten zu können.

Aus der Patentanmeldungsveröffentlichung FR 2 565 695 A1 ist ein Verfahren mit den Merkmalen des Oberbegriffs von Anspruch 1 sowie eine Vorrichtung mit den Merkmalen des Oberbegriffs von Anspruch 6 bekannt. Aus der Patentschrift US 4 103 233 A und der Patentanmeldungsveröffentlichung DE 10 2008 042 095 A1 sind weitere Verfahren sowie Vorrichtungen zur Bestimmung der Eindringtiefe eines Betätigungsglieds in eine Spule bekannt.

OFFENBARUNG DER ERFINDUNG

AUFGABE DER ERFINDUNG

Dementsprechend ist es die Aufgabe der vorliegenden Erfindung, ein zuverlässiges Verfahren zum Messen zumindest einer Eigenschaft einer Spule bereitzustellen, wobei beispielsweise eine solche Eigenschaft ermittelt werden kann, die von der Feuchtigkeit in der Spule abhängig ist. Die Aufgabe besteht auch in der Bereitstellung einer entsprechenden Vorrichtung. Ferner ist es die Aufgabe der Erfindung, eine Positionsmessung (bzw. Wegmessung) bzgl. eines Betätigungsglieds zu erleichtern, das in eine solche Messspule eintaucht, insbesondere wenn die Messspule nicht wasserdicht versiegelt ist. Alternativ oder mit einem anderen seiner Abschnitte kann sich ein Betätigungsglied auch über eine solche Messspule schieben. Die Aufgabe besteht auch in der Bereitstellung einer entsprechenden Vorrichtung. Zur Aufgabe gehört schließlich das Bereitstellen entsprechender Kraftfahrzeuge mit entsprechenden Spulen und Betätigungsgliedern, bei denen auf ein Versiegeln der Spulen verzichtet werden kann.

TECHNISCHE LÖSUNG

Diese Aufgabe wird gelöst durch ein Verfahren mit den Merkmalen des Anspruchs 1 und durch eine Vorrichtung mit den Merkmalen des Anspruchs 6.

Nach einem Aspekt der Erfindung, für den selbstständig und in Kombination mit anderen Aspekten der Erfindung Schutz begehrt wird, wird die Aufgabe durch ein Verfahren zum Messen zumindest einer Eigenschaft einer Spule, vorzugsweise einer bei Messungen anderer Größen eingesetzten Messspule gelöst. Erfindungsgemäß wird die Spule als Parallelschaltung erstens einer Kapazität mit zweitens einer Reihenschaltung aus einem Gleichspannungswiderstand, einem frequenzabhängigen Widerstand und einer Induktivität modelliert. (Dies beinhaltet eine abstrakte Betrachtung, die allerdings eine spätere Abfrage nach den entsprechenden Größen zur Folge hat.) Es wird ein Strom-Spannungswandler in Reihe zu der Spule geschaltet. Es wird die Spule sodann mit einer eine erste Frequenz aufweisenden Wechselspannung mit von Null verschiedenem Gleichspannungsanteil beaufschlagt (also mit Gleichspannungsoffset) und die Spannung am Strom-Spannungswandler mit einer zweiten Frequenz erfasst (abgetastet), die ein Vierfaches oder ein Mehrfaches eines Vierfachen der ersten Frequenz ist. Aus mindestens vier der so in Folge erfassten Messwerte werden die Impedanz und der Phasenwinkel bei der ersten Frequenz abgeleitet. Aus diesen Größen kann dann ein Wert für den Gleichspannungswiderstand, den frequenzabhängigen Widerstand und/oder die Induktivität abgeleitet werden. Alternativ kann die zweite Frequenz auch ein höheres Vielfaches als das Vierfache der ersten Frequenz sein, also ein n-faches der ersten Frequenz sein, wobei n eine natürliche Zahl größer als 4 ist, und Impedanz und Phasenwinkel werden dann aus mindestens n in Folge erfassten Messwerten abgeleitet.

Zusätzlich bzw. anschließend wird die Spule mit einer eine von der ersten Frequenz verschiedene dritte Frequenz aufweisenden Wechselspannung mit von Null verschiedenem Gleichspannungsanteil beaufschlagt (also mit

Gleichspannungsoffset) und die Spannung am Strom-Spannungswandler mit der zweiten Frequenz oder mit einer vierten Frequenz erfasst (abgetastet), die ein Vierfaches oder ein höheres Vielfaches der dritten Frequenz ist und aus mindestens vier oder eben mehr der so in Folge erfassten Messwerte werden die Impedanz und der Phasenwinkel bei der dritten Frequenz abgeleitet: Hier kann dann aus den beiden Impedanzen und den beiden Phasenwinkeln der Wert für den Gleichspannungswiderstand, den frequenzabhängigen Widerstand und/oder die Induktivität abgeleitet werden. Bei insgesamt acht Werten können die drei Größen zuverlässig, also mit geringem Messfehler, ermittelt werden. Das oben genannte Modell der Spule als Parallelschaltung erstens einer Kapazität mit zweitens einer Reihenschaltung aus einem Gleichspannungswiderstand, einem frequenzabhängigen Widerstand und einer Induktivität gewinnt also durch die Berechnung der entsprechenden letzteren Größen seine Berechtigung.

In einer vorteilhaften Ausführungsform kann die Wechselspannung in beiden Schritten bzw. die Wechselspannung mit der ersten und der dritten Frequenz jeweils eine sinusförmige Spannung sein, wobei sich die Spannungen in ihrer Frequenz voneinander unterscheiden. Es hat sich dabei als besonders effizient erwiesen, wenn die dritte Frequenz das Dreifache der ersten Frequenz beträgt.

Die unterschiedlichen Frequenzen können auch durch eine Rechteckspannung bereitgestellt werden, die durch unterschiedliche Filter geleitet wird, nämlich indem die Grundwelle und die dritte Oberwelle (mit dem Dreifachen der Frequenz der Grundwelle) durchgelassen werden.

Die vier (oder mehr) in Folge erfassten Messwerte beim Vierfachen oder höheren Vielfachen der Frequenz sollen den Strom bzw. die Spannung phasensynchron in Winkelabständen von 90° bezüglich der Phase der Wechselspannung abtasten. Bevorzugt erfolgt dieses Abtasten bei den Phasenwerten 0°, 90°, 180° und 270°. Gleichwohl sind andere Werte möglich, beispielsweise könnte bei 15°, 105°, 195° und 285° ein Abtasten erfolgen oder dgl..

Gemäß einem Verfahren zum Messen einer Position eines Betätigungsglieds taucht das Betätigungsglied in zumindest einer messbaren Position zumindest abschnittsweise in eine Messspule ein und/oder schiebt sich zumindest abschnittsweise über eine Messspule, ändert also das Ausmaß, mit dem das Betätigungsglied die Spule umgibt, wobei die Position aus einer Induktivität der Messspule abgeleitet wird. Bei zumindest zwei unterschiedlichen Frequenzen können die jeweiligen Imaginärteile der Impedanz der Messspule ermittelt werden, und daraus kann eine von einer Kapazität der Messspule unabhängige ideale Induktivität ermittelt werden. Diese ideale Induktivität ist nur noch von mechanischen Größen wie dem Weg (Position der Messspule) abhängig, ggf. noch von der Temperatur. Entsprechend wird unter Verwendung dieser idealen Induktivität in dem Verfahren die Position abgeleitet.

Unter Vernachlässigung der in einem Modell der Spule ebenfalls vorhandenen Widerstände, nämlich "Gleichspannungswiderstand" und "frequenzabhängiger Widerstand", lässt sich die folgende Formel ableiten, zu der sich die ideale Induktivität L0 bei der ersten Frequenz $\omega_1$ mit entsprechender Impedanz $Z_1$ und entsprechendem Imaginärteil $Im\{Z_1\}$ und bei der zweiten Frequenz $\omega_2$ mit der Impedanz $Z_2$ und entsprechendem Imaginärteil $Im\{Z_2\}$ berechnet:

$$L_0 = \frac{Im\{Z_1\} \cdot Im\{Z_2\} \cdot \left(\frac{\omega_1}{\omega_2} + \frac{\omega_2}{\omega_1}\right)}{\omega_2 Im\{Z_2\} - \omega_1 Im\{Z_1\}}$$

Bei einer temperaturabhängigen idealen Induktivität kann noch eine Messung der Temperatur vorgesehen werden, wobei der Messwert für die Temperatur bei der Ermittlung der Position eingesetzt werden kann.

Die beiden Impedanzen können nach dem Verfahren gemäß dem ersten Aspekt der Erfindung ermittelt werden, d.h. mit jeweils vier (oder mehr) Messwerten bei beiden Frequenzen, die bevorzugt eben phasensynchron in 90°-Abständen (oder entsprechenden kleineren Abständen) die Spannung am Strom-Spannungswandler wiedergeben.

Bei der erfindungsgemäßen Vorrichtung zum Messen zumindest einer Eigenschaft einer Spule ist gemäß dem zweiten Aspekt der Erfindung, für den ebenfalls unabhängig und in Kombination mit anderen Aspekten der Erfindung Schutz begehrt wird, ein Strom - Spannungswandler (vorzugsweise in Form eines einfachen Messwiderstands) bereitgestellt, der mit der Spule in Reihe zu schalten ist, ferner ein Generator für eine Eingangs - Wechselspannung, die einen Gleichspannungsanteil aufweist, ein Frequenzwandler, wobei eine eine erste Frequenz aufweisende Wechselspannung und eine eine von der ersten Frequenz verschiedene dritte Frequenz aufweisende Wechselspannung erzeugt werden, eine Abtastschaltung für das Ausgangssignal des Strom - Spannungswandlers, die ein zur Eingangs - Wechselspannung phasensynchrones Abtasten mit der vierfachen Frequenz oder einem höheren Vielfachen als der vierfachen Frequenz der Eingangs - Wechselspannung bewirkt, und es ist schließlich eine Auswerteeinrichtung bereitgestellt, der die von der Abtastschaltung abgetasteten Messwerte zugeführt werden, und die unter Modellierung der Spule als Parallelschaltung erstens einer Kapazität mit zweitens einer Reihenschaltung aus einem Gleichspannungswiderstand, einem frequenzabhängigen Widerstand, und einer Induktivität den Wert bzw. die Werte für den Gleichspannungswiderstand, für den frequenzabhängigen Widerstand und/oder die Induktivität berechnet.

Der Frequenzwandler kann ein Frequenzvervielfältiger oder Frequenzteiler sein, der optional einschaltbar ist.

Bei einer Ausführungsform kann die Abtastschaltung hinter dem Ausgang des Frequenzwandlers und hinter dem Ausgang des Strom-Spannungswandlers jeweils einen Tiefpassfilter beinhalten, und die Ausgänge beider Tiefpassfilter können einem Multiplexer zugeführt werden, dessen Ausgang einem Analog-Digital-Wandler zugeführt werden kann, dessen Ausgang seinerseits einer Mikroprozessor - Auswerteeinrichtung zugeführt werden kann. Bei einer alternativen Ausführungsform kann die Abtastschaltung das Ausgangssignal des Frequenzwandlers und des Strom - Spannungswandlers zusammen einem Multiplexer zugeführt werden, dessen Ausgangssignal erstens einen Tiefpassfilter durchlaufen kann, dessen Ausgang einem ersten Analog - Digital - Wandler zugeführt werden kann, dessen Ausgang seinerseits einem Mikroprozessor als Auswerteeinrichtung zugeführt werden kann, und das Ausgangssignal des Multiplexers kann zweitens einem Bandpassfilter zugeführt werden, dessen Ausgangssignal entweder dem selben ersten Analog - Digital - Wandler oder einem zweiten Analog - Digital - Wandler zugeführt werden kann, dessen Ausgangssignal seinerseits dem Mikroprozessor zugeführt werden kann.

Die erste Ausführungsform mit den beiden frühen Tiefpassfiltern hat den Vorteil, dass Störsignale sehr frühzeitig herausgefiltert werden können. Die Ausführungsform mit dem am Anfang stehenden Multiplexer hat den Vorteil, dass sehr phasengenau gemessen werden kann.

Eine Vorrichtung zum Messen einer Position eines Betätigungsglieds, die eine Messspule aufweist, in die das Betätigungsglied in zumindest einer zu messenden Position eintaucht, kann eine Vorrichtung zum Messen der Impedanz der Messspule oder zumindest des Imaginärteils der Impedanz der Messspule bei zwei unterschiedlichen Frequenzen zum Ermitteln einer von der Kapazität der Messspule unabhängigen idealen Induktivität der Spule und eine Einrichtung zum Ermitteln der Position des Betätigungsglieds aus dieser idealen Induktivität aufweisen, was aufgrund der Eigenschaft der idealen Induktivität auch tatsächlich ableitbar ist.

Bei dieser Vorrichtung muss die Messspule nicht wasserdicht versiegelt sein, da die Kapazität vor der Ermittlung der Position des Betätigungsglieds herausgerechnet wird und da eintretende Feuchtigkeit hauptsächlich die Kapazität beeinflusst.

Vorzugsweise kann in der Vorrichtung zum Messen einer Position eines Betätigungsglieds die Vorrichtung zum Messen zumindest einer Eigenschaft einer Spule Verwendung finden.

Ein Kraftfahrzeug kann ein ein Betätigungsglied aufweisendes Betätigungselement sowie eine Vorrichtung zum Messen einer Position des Betätigungsglieds aufweisen. Das Betätigungsglied des Betätigungselements taucht zumindest abschnittsweise in die Messspule der Vorrichtung zum Messen einer Position des Betätigungsglieds ein und/oder schiebt sich zumindest abschnittsweise über diese und in Abhängigkeit von der Position des Betätigungsglieds wird zumindest unter vorbestimmten Bedingungen eine Reaktion einer Einheit des Kraftfahrzeugs veranlasst. Das Betätigungselement kann ein Brems - oder Gaspedal sein oder ein anderes Element eines Kfz, dessen Position, also Wegstrecke und/oder Winkel, veränderbar ist und ermittelt werden soll.

Neben der Anwendung der vorliegenden Erfindung in einem Kraftfahrzeug kann die Erfindung auch bei anderen industriellen Anwendungen eingesetzt werden, bei denen Spulen als vergleichbare Positionssensoren eingesetzt werden können, wie im Maschinenbau, z.B. bei Werkzeugmaschinen, oder Mess - oder Testvorrichtungen.

KURZBESCHREIBUNG DER FIGUREN

Die beigefügten Zeichnungen zeigen in rein schematischer Weise in

Fig. 1 das Prinzip der Wegmessung bei einem Pedal, wie es der vorliegenden Erfindung in einigen Aspekten zugrundeliegt,

Fig. 2 ein Ersatzschaltbild, gemäß dem eine durch das Prinzip nach Fig. 1 vorgesehene Messspule modelliert wird,

Fig. 3A ein Prinzipschaltbild einer in Reihe mit einem Widerstand geschalteten Induktivität und in

Fig. 3B ein hierzu passendes Zeigerdiagramm mit Zeigern für Strom und Spannung,

Fig. 4A eine Abwandlung der Prinzipschaltung aus Fig. 3A mit Strom - Spannungswandler,

Fig. 4B ein hierzu passendes Zeigerdiagramm,

Fig. 5A das Prinzip der Abtastung von Messwerten im 90° - Abstand,

Fig. 5B ein hierzu passendes Zeigerdiagramm,

Fig. 6 ein Schaltbild, das das Grundprinzip der bei einer Ausführungsform der Erfindung verwendeten Spannungserzeugung veranschaulicht,

Fig. 7A - 7C hierzu die an mehreren in Fig. 6 gezeigten Punkten abgegriffenen Spannungen,

Fig. 8 ein Prinzipschaltbild einer Schaltung, die unter Verwendung des anhand von Fig. 6 erläuterten Prinzips der Durchführung des Verfahrens zum Ermitteln zumindest einer Eigenschaft der Messspule dient,

Fig. 9 ein zur Erläuterung der Erfindung verwendetes Zeigerdiagramm,

Fig. 10A eine zweite Ausführungsform einer erfindungsgemäßen Schaltung mit einem Frequenzteiler,

Fig. 10B die hierzu gehörige Auswerteschaltung im weiteren Detail veranschaulicht,

Fig. 11A eine dritte Ausführungsform einer erfindungsgemäßen Schaltung mit einem Flipflop,

Fig. 11B die hierzu gehörige Auswerteschaltung im Detail bei geringer Abwandlung,

Fig. 12 ein abgewandeltes Ersatzschaltbild für eine gemäß dem Prinzip nach Fig. 2 vorgesehene Messspule, und in

Fig. 13 eine Abwandlung des Prinzips der Wegmessung nach Fig. 1.

AUSFÜHRUNGSBEISPIELE

Weitere Vorteile, Kennzeichen und Merkmale der vorliegenden Erfindung werden bei der nachfolgenden Beschreibung von Ausführungsbeispielen deutlich, wobei die Erfindung nicht auf diese Ausführungsbeispiele beschränkt ist.

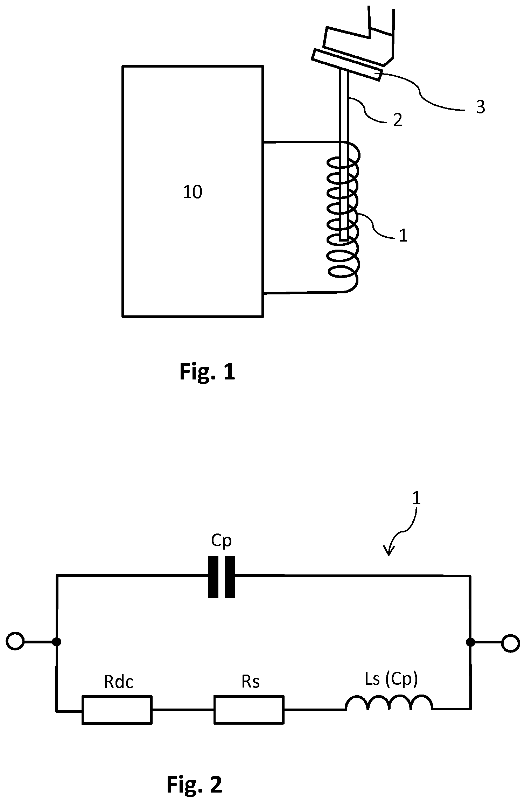

Die Fig. 1 zeigt ein Betätigungsglied 2 an einem Pedal 3, das eine Spule 1 durchdringt, wie es beispielsweise in einem Kraftfahrzeug eingesetzt wird, und eine Vorrichtung 10 zum Auslesen des Wegsignals aus der Spule 1.

Die Spule 1 kann, wie in Fig. 2 veranschaulicht, als Parallelschaltung erstens einer Kapazität Cp und zweitens einer Reihenschaltung aus einem Gleichspannungswiderstand Rdc, einem frequenzabhängigen Widerstand Rs und einer Induktivität Ls modelliert werden. Die Größe Ls ist von mechanischen Eigenschaften abhängig, insbesondere wegabhängig, also abhängig von der Position des Betätigungsglieds 2 des Pedals 3 und beispielsweise auch der Temperatur abhängig. Auch Rs ist wegabhängig. Zudem ist es von der Mechanik und dem Windungsschluss abhängig. Der Gleichspannungswiderstand Rdc ist von der Temperatur der Spule 1 und dem Kontaktwiderstand daran abhängig. Die Kapazität Cp der Windungen der Spule 1 hängt hauptsächlich von der in der Spule herrschenden Feuchtigkeit ab.

Die vorliegende Erfindung beschreibt eine Möglichkeit, wie von dem üblichen Prinzip, die Kapazität Cp konstant zu halten, indem die Spule 1 wasserdicht versiegelt wird, abgegangen werden kann.

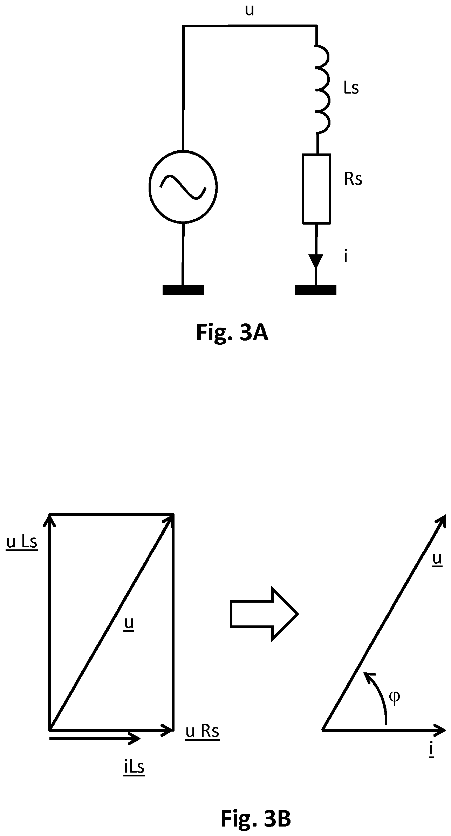

Wie bekannt, kann eine Reihenschaltung aus Induktivität Ls und frequenzabhängigem Widerstand Rs, wie sie in Fig. 3A im Prinzipschaubild dargestellt ist, bei Beaufschlagung mit einer Wechselspannung U durch ein in Fig. 3B gezeigtes Zeigerdiagramm dargestellt werden. Die resultierende Spannung weist einen Winkel (Phasenwinkel $\varphi$) auf und einen Betrag. Die Impedanz kann aus dem Winkel $\varphi$ und dem Betrag errechnet werden.

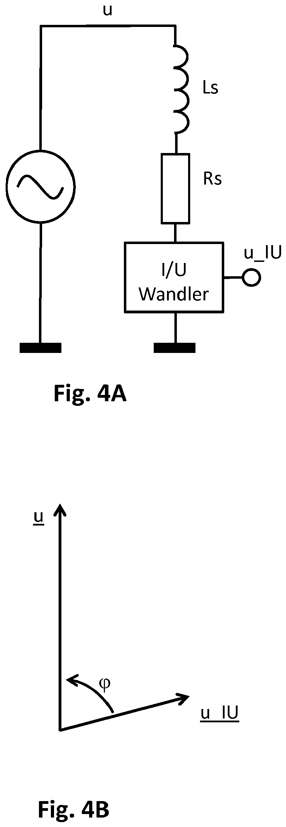

Im weniger idealisierten Prinzipschaubild gibt es zusätzlich noch einen Strom - Spannungswandler, an dem die Spannung u_IU abgegriffen werden kann, siehe Fig. 4A und das zugehörige Zeigerschaubild in Fig. 4B. Auch hier lässt sich der Phasenwinkel $\varphi$ ermitteln, nunmehr im Verhältnis zweier Spannungen u und u_IU zusammen.

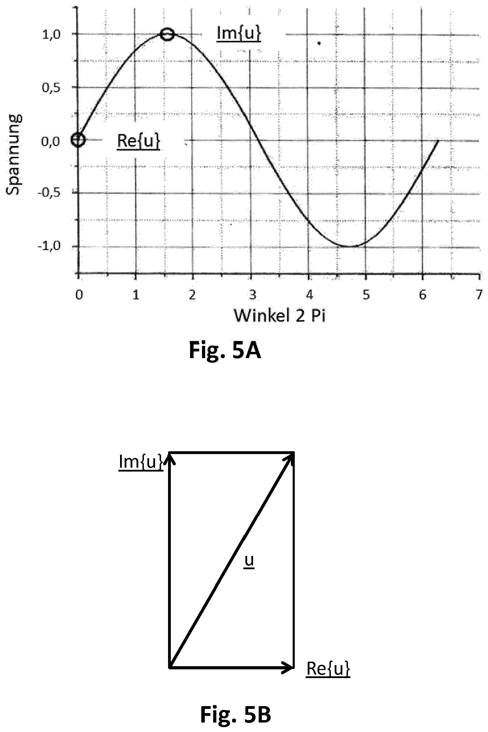

Die in den Figuren 3B und 4B gezeigten Zeigerdarstellungen sind bei einer Wechselspannung Momentaufnahmen, beim Betrieb dreht sich der Zeiger mit einer konstanten Drehfrequenz $\omega_1$ (der Frequenz der Wechselspannung), sodass der Realteil des Zeigers bei einem bestimmten Phasenwinkel ablesbar ist, der Imaginärteil bei einem anderen Phasenwinkel, der um 90° versetzt ist. Dies wird anhand der Fig. 5A ersichtlich, wo bei einem Winkel von Null (gemessen in Bogenlängen, also eine volle Umdrehung beträgt $2\pi$, 6,28...) der Realteil ablesbar ist, und wobei der Imaginärteil bei einem Winkel von 90° ($\pi/2$) ablesbar ist. Fig. 5B zeigt das entsprechende Zeigerdiagramm.

Die Erfindung beruht auf der Erkenntnis, dass aus entsprechenden Messungen von Real- und Imaginärteilen die Impedanz und der Phasenwinkel ableitbar sind und daraus die Größen Rdc, Rs und Ls berechenbar sind.

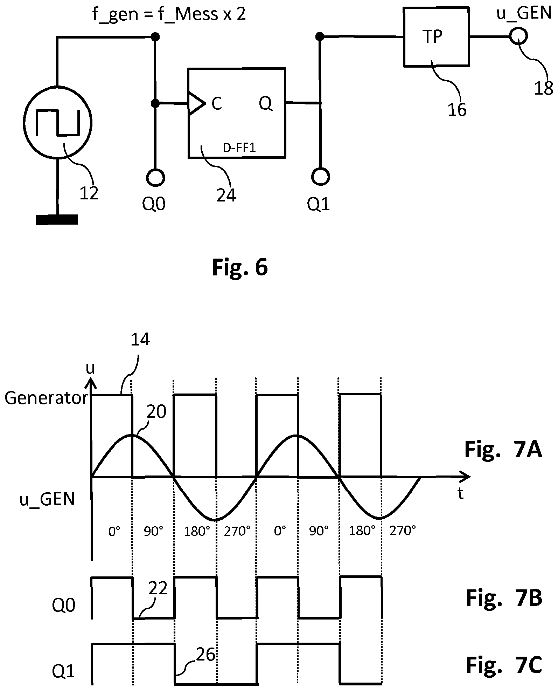

Die Ausführungsform geht von der Idee aus, dass ein Abtasten von Messwerten bei 0°, 90°, 180° und 270° erfolgen soll. Hierzu zeigt Fig. 6 ein Prinzipschaubild des entsprechenden Spannungsgenerator - Komplexes.

Ein Spannungsgenerator 12 erzeugt eine Rechteckspannung 14 (Fig. 7A), die durch einen Tiefpassfilter 16 geleitet wird, dessen Ausgang 18 die Generatorspannung u_GEN (siehe Kurve 20 in Fig. 7A) ausgibt. Vor dem Tiefpassfilter wird an einem Abgriff Q0 die in Fig. 7B gezeigte Spannung 22 (Fig. 7B) abgegriffen, wobei einem Frequenzteiler 24 ein Ausgang Q1 folgt, wo die Spannung 26 (Fig. 7C) abgreifbar ist. Durch Verwendung der Größen Q0 und Q1 ist es möglich, im Winkel von 90° Abtastungen vorzunehmen.

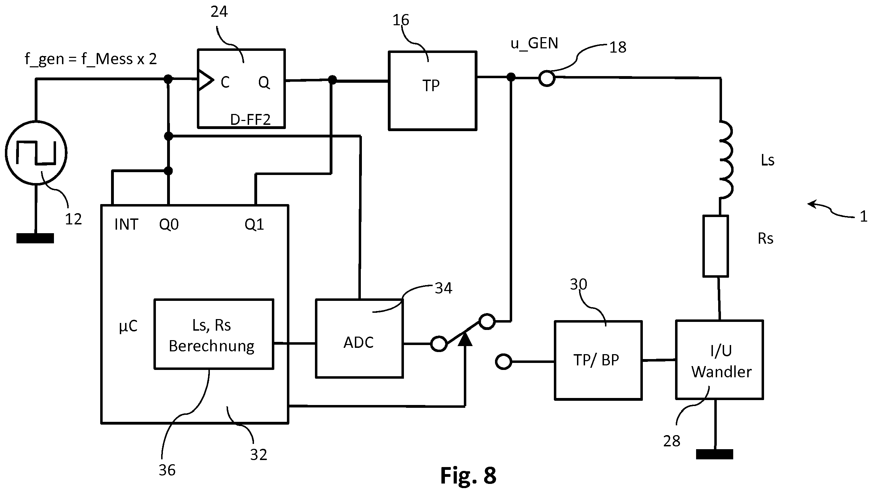

Das vollständige Schaubild ist in Fig. 8 gezeigt. In Reihe zur Spule 1, die am Ausgang 18 angeschlossen ist, wird ein Strom - Spannungswandler 28 geschaltet, der beispielsweise als einfacher Messwiderstand R_FP ausgestaltet ist. Auf den Strom - Spannungswandler folgt ein Tiefpass oder Bandpass 30. Ein Mikroprozessor 32 erhält die Spannungen gemäß Fig. 7B und 7C an seinen Eingängen Q0 bzw. Q1 und steuert die Zufuhr von Signalen zu einem Analog - Digital - Wandler 34 (also die Abtastung), dem seinerseits auch die ursprüngliche Rechteckspannung 14 zugeführt wird. Im Mikroprozessor 32 gibt es eine Einheit 36, die die Werte Rs und Ls, ggf. auch Rdc berechnet.

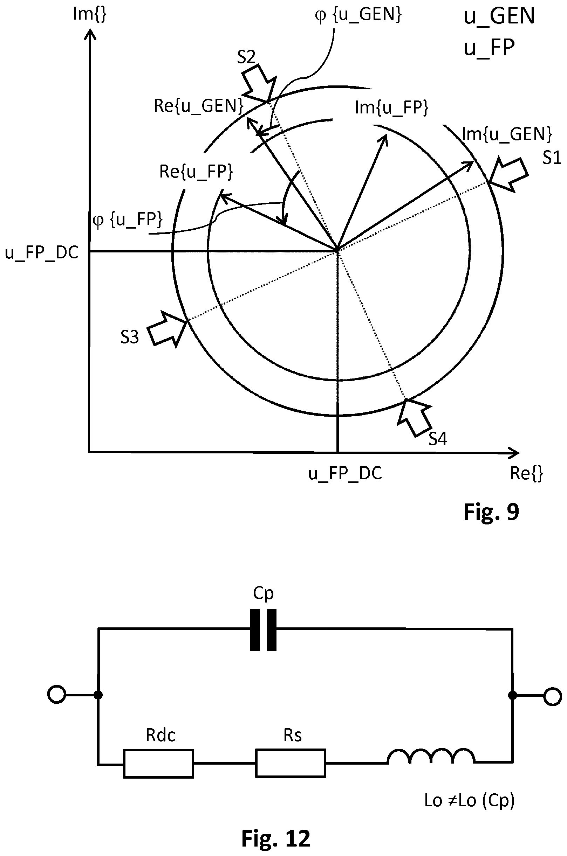

Wie oben ausgeführt, soll in Winkelabständen von 90° die Spannung abgetastet werden. Dies ist in Fig. 9 anhand der Abtastwerte ("sample") S1, S2, S3 und S4 veranschaulicht. Zu beachten ist, dass wegen der Rechteckspannung ein Gleichspannungsanteil, der von Null verschieden ist, dem gesamten System aufgeprägt ist. Der Gleichspannungsanteil in der Generatorspannung ergibt sich zu:

$$\text{ØU\_GEN\_DC} = \frac{\frac{u_{GEN_{0°}} + u_{GEN_{180°}}}{2} + \frac{u_{GEN_{90°}} + u_{GEN_{270°}}}{2}}{2} \tag{1}$$

und entsprechend ergibt sich der Gleichspannungsanteil am Strom-Spannungswandler - Widerstand R_FP zu:

$$\text{ØU\_FP\_DC} = \frac{\frac{u_{FP_{0°}} + u_{FP_{180°}}}{2} + \frac{u_{FP_{90°}} + u_{FP_{270°}}}{2}}{2} \tag{2}$$

Die Größen u_GEN_0°, u_GEN_90°, u_GEN_180°, u_GEN_270° sind Abtastwerte für die Generatorspannung, die bei den Winkeln mit der Phase 0°, 90°, 180° bzw. 270° gemessen werden. Entsprechendes gilt für die Werte u_FP_0°, u_FP_90°, u_FP_180°, u_FP_270° für die Spannung am Strom - Spannungswandler.

Aus beiden Größen lässt sich sodann der Wert Rdc, der in der Spule 1 steckende Gleichspannungswiderstand, ableiten gemäß:

$$\text{Rdc} = \frac{\text{Ø} u_{GEN_{DC}} * R_{FP}}{\text{Ø} u_{FP_{DC}}} - R_{FP} \tag{3}$$

Mit Hilfe von Ø $u_{GEN\_DC}$ und Ø $u_{FP\_DC}$ ist es jetzt möglich, den Gleichspannungsanteil aus den Abtastwerten herauszurechnen.

Eine Impedanz Z ergibt sich zu:

$$Z = \frac{u_{GEN}}{u_{FP}} * R_{FP} - (R_{FP} + Rdc) \tag{4}$$

und entsprechend ergibt sich der frequenzabhängige Widerstand Rs zu:

$$Rs = \frac{u_{GEN_{0°}} * u_{FP_{0°}} + u_{GEN_{90°}} + u_{FP_{90°}}}{u_{FP_{0°}}{}^2 + u_{FP_{90°}}{}^2} * R_{FP} - (R_{FP} + Rdc) \tag{5}$$

und die Induktivität Ls zu:

$$Ls = \frac{u_{GEN_{90°}} * u_{FP_{0°}} + u_{GEN_{0°}} + u_{FP_{90°}}}{u_{FP_{0°}}{}^2 + u_{FP_{90°}}{}^2} \tag{6}$$

Die Größe Ls ist somit nichts anderes als der Imaginärteil der jeweiligen Impedanz, Ls = Im{Z}.

Nachfolgend werden zwei Ausführungsformen der Schaltung im Detail näher erläutert.

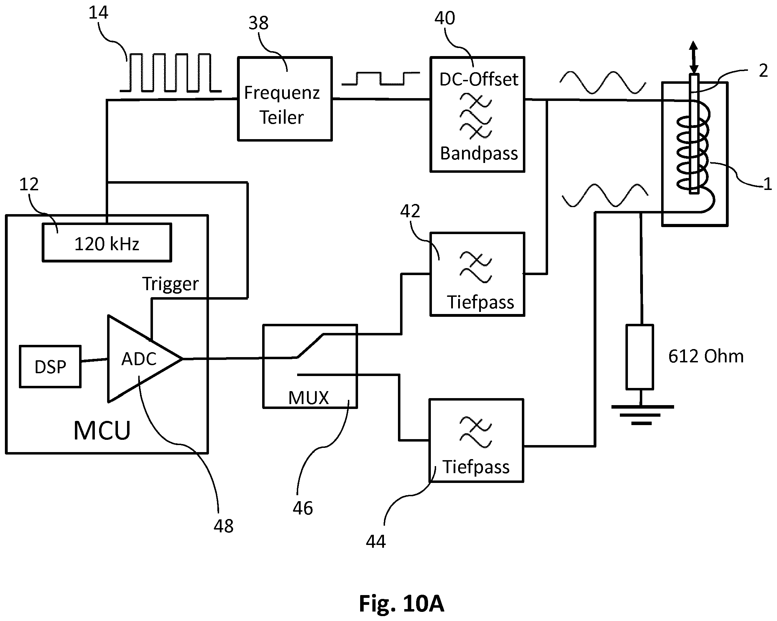

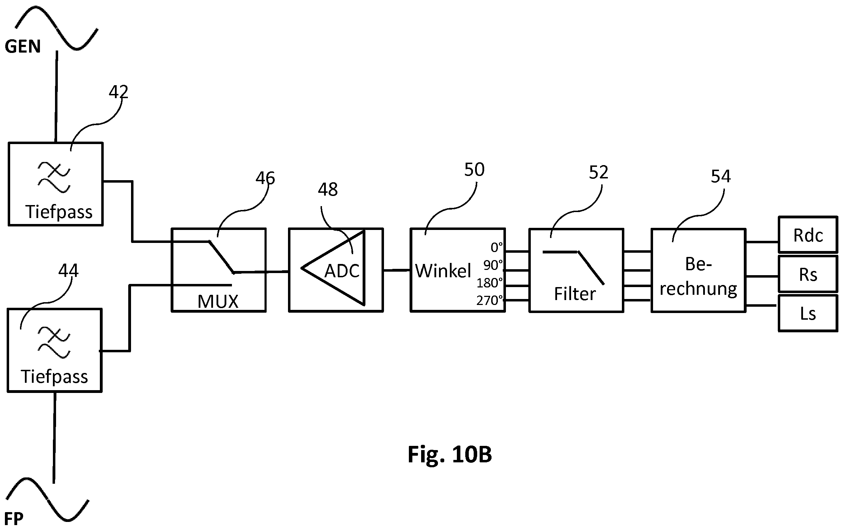

Fig. 10A zeigt, dass eine vom Generator 12 mit einer Frequenz von im vorliegenden Beispiel 120 kHz erzeugte Rechteckspannung einen Frequenzteiler 38 durchläuft, diese Spannung sodann einen Bandpass 40 mit Gleichspannungsoffset durchläuft und der Spule 1 zugeführt wird. Das Eingangssignal für die Spule (also der Ausgang des Bandpasses 40) durchläuft einen Tiefpass 42, das Ausgangssignal der Spule einen weiteren Tiefpass 44, und die Ausgänge beider Tiefpässe werden in einem Multiplexer 46 miteinander gemultiplext, das Ergebnis wird einem Analog - Digital-wandler 48 zugeführt, wo sodann eine Auswertung erfolgt. Wie in Fig. 10B im weiteren Detail dargestellt ist, werden nach dem Analog - Digital - Wandler die Winkel 0°, 90°, 180° und 270° in einer Einheit 50 ausgelesen, durchlaufen sodann einen Filter 52, bevor die Berechnung 54 gemäß den obigen Formeln erfolgt und die Größen Rdc, Rs und Ls ausgegeben werden.

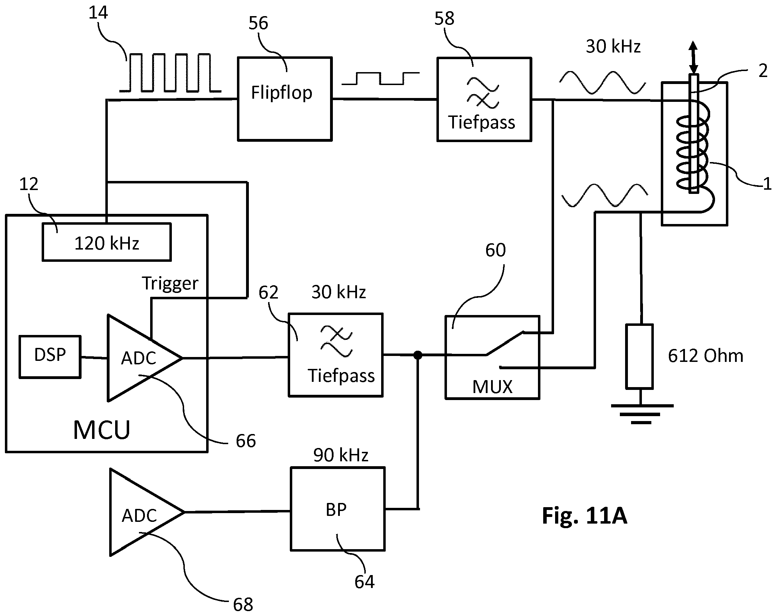

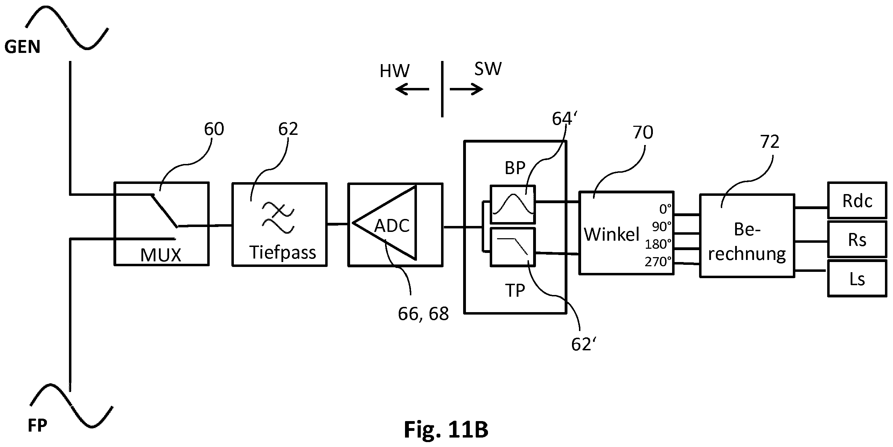

In Abwandlung der Ausführungsform gemäß Fig. 10A durchläuft gemäß Fig. 11A die von dem Generator 12 erzeugte Rechteckspannung 14 mit im vorliegenden Beispiel 120kHz einen Flipflop 56, dessen Ausgang einem Tiefpass 58 zugeführt wird, wo beispielsweise eine Frequenz von 30 kHz ausgegeben wird. Der Ausgang des Tiefpass 58 und der Ausgang der Spule 1 werden in einem Multiplexer 60 gemultiplext und dies sodann einem weiteren Tiefpass 62 und in einem anderen Zweig einem Bandpass 64 zugeführt, denen jeweilige Analog - Digital - Wandler 66 bzw. 68 nachfolgen. Diese Auswertung ist im Detail in Fig. 11B veranschaulicht, wobei in Fig. 11B durch die Angabe "HW" und "SW" gezeigt ist, welche Einheiten in Form von Hardware "HW", also physikalischen Baugruppen vorliegen, und welche Einheiten durch eine Software "SW", also in einer Recheneinheit bereitgestellt sind. Der Multiplexer 60 kann auch durch zwei Multiplexeinheiten bereitgestellt sein, um Messzeiten zu verringern. Anstelle zweier Analog - Digital - Wandler 66 und 68 kann auch ein einzelner Analog - Digital - Wandler mit vorgeschaltetem weiteren Multiplexer eingesetzt werden.

In geringer Abwandlung von Fig. 11A ist in Fig. 11B der Bandpass zu einem späteren Zeitpunkt dargestellt, siehe Einheit 64' mit dem Tiefpass 62' im parallelen Zweig. Die Einheit 70 ermittelt sodann die entsprechenden Größen bei den Winkeln 0°, 90°, 180° und 270°, die Einheit 72 berechnet die Größen Rdc, Rs und Ls.

Das bisher beschriebene Verfahren dient dazu, die gemäß dem in Fig. 2 dargestellten Modell vorliegenden Eigenschaften der Spule 1 zu ermitteln, also die Widerstände Rdc, Rs und die Induktivität Ls. Die Induktivität Ls ist noch von Cp abhängig.

Um die Wegmessung zuverlässig durchzuführen, also die Position des Betätigungsglieds 2 präzise zu ermitteln, berechnet man nun andere Größen gemäß dem Modell nach Fig. 12. Hier gibt es eine Induktivität L0, die nicht von Cp abhängig ist, und die Anhängigkeit von Cp findet sich in den anderen Größen wieder.

Die Impedanz der Spule kann gemäß Fig. 12 dargestellt werden als:

$$\underline{Z} = \frac{1}{\frac{1}{Rdc+Rs+j\omega L0}+j\omega Cp} \tag{7}$$

Die bei dem Ermitteln der theoretischen Induktivität L0 eingesetzte Idee besteht darin, dass die Induktivität bei verschiedenen Frequenzen $\omega 1$ und $\omega 2$ gemessen wird. Bei $\omega 1$ lautet die Formel für die Induktivität:

$$\underline{Z}_1 = \frac{1}{\frac{1}{Rdc+Rs+j\omega_1 L0}+j\omega_1 Cp} , \tag{8}$$

bei $\omega 2$ lautet sie:

$$\underline{Z}_2 = \frac{1}{\frac{1}{Rdc+Rs+j\omega_2 L0}+j\omega_2 Cp} . \tag{9}$$

Setzt man nun in einer Näherung Rdc = Rs =0, dann erhält man für den Imaginärteil der Impedanz $Z_1$ und der Impedanz $Z_2$ die folgenden Größen:

$$\text{Im}\{\underline{Z_1}\} = \frac{1}{\frac{1}{\omega_1 L0} + j\omega_1 Cp} \qquad (10)$$

$$\text{Im}\{\underline{Z_2}\} = \frac{1}{\frac{1}{\omega_2 L0} + j\omega_2 Cp} \cdot \qquad (11)$$

Dies kann man nach L0 auflösen, und man erhält die Formel:

$$L0 = \frac{\text{Im}\{Z_1\} \cdot \text{Im}\{Z_2\} \cdot (\frac{\omega_1}{\omega_2} + \frac{\omega_2}{\omega_1})}{\omega_2 \text{Im}\{Z_2\} - \omega_1 \text{Im}\{Z_1\}} \cdot \qquad (12)$$

In den obigen Beispielen ist es ersichtlich, dass, wenn die erste Messfrequenz w1 beispielsweise 25kHz beträgt, die zweite Messfrequenz ω2 die dritte Oberwelle betrifft, also 75kHz betrifft, und dass das Abtasten bei 100kHz erfolgt. Eine dritte Messfrequenz könnte theoretisch das Fünffache der ersten Messfrequenz betragen, also 125kHz. Auch bei Letzterem entsteht durch Abtasten mit 100kHz eine Frequenz von 25kHz, die abgetasteten Werte müssen allerdings dann in geeigneter Reihenfolge eingesetzt werden.

Man kann nun mit der ermittelten Größe L0, die lediglich noch von der Temperatur abhängig sein könnte, die Position des Betätigungsglieds 2 eindeutig ableiten, ggf. kann mit der Hilfe von Rdc die Temperaturabhängigkeit auch zusätzlich noch kompensiert werden. Auf diese Weise ist es möglich, die Spule 1 unversiegelt zu verwenden, also ohne, dass sie vor Feuchtigkeit geschützt werden müsste.

Die oben beschriebenen Messungen der Größen Rdc, Rs und Ls und daraus folgernd der Größe L0 können in einem Kraftfahrzeug beispielsweise im Fünf-Minuten-Takt, Viertelstunden-Takt oder anderen Takten mit einer Dauer zwischen 1 sec und 24h, vorzugsweise mit einer Dauer zwischen 1 sec und 1h, durchgeführt werden. Bei der Betätigung eines entsprechenden Pedals 3 wird so der jeweils aktuelle Wert für die Kapazität Cp, der von einer eventuell eintretenden Feuchtigkeit in die Spule 1 abhängig ist, zuverlässig berücksichtigt.

In Abwandlung zur Fig. 1 kann ein Betätigungsglied 2' an einem Pedal 3 eine Spule 1' auch umgeben, wobei durch Betätigung des Pedals 3 das Ausmaß, inwieweit das Betätigungsglied 2' die Spule 1' umgibt, variiert wird. Das Betätigungsglied 2' wird also über die Spule 1' geschoben.

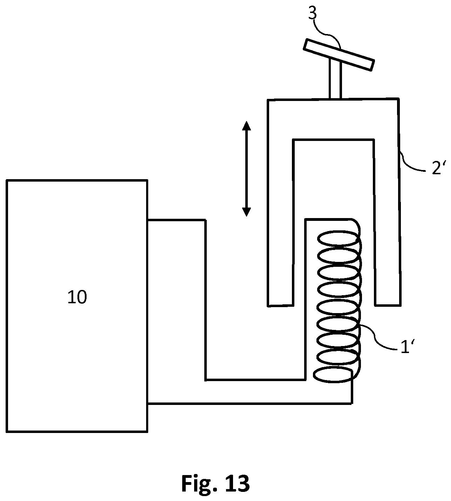

In weiterer Abwandlung wäre bei einer nicht gezeigten Ausführungsform auch eine Kombination der Prinzipien nach Fig. 1 und Fig. 13 möglich, d.h. ein Betätigungsglied kann mit einem inneren Abschnitt die Spule durchdringen und mit einem äußeren Abschnitt die Spule umgeben und sich über diese schieben.

Das Betätigungsglied 2 oder 2' kann anstatt an einem Pedal 3 auch an einer Handhabe oder einer sonstigen mechanisch verschieblichen Einheit als Betätigungselement angeordnet sein.

Obwohl die vorliegende Erfindung anhand der Ausführungsbeispiele detailliert beschrieben worden ist, ist die Erfindung nicht auf diese Ausführungsbeispiele beschränkt, sondern es sind vielmehr Abweichungen in der Weise möglich, dass einzelne Merkmale weggelassen oder andersartige Kombinationen von Merkmalen verwirklicht werden können, solange der Schutzbereich der beigefügten Ansprüche nicht verlassen wird. Die vorliegende Offenbarung schließt sämtliche Kombinationen der vorgestellten Einzelmerkmale mit ein.

Insbesondere kann ein Abtasten von Messwerten bei 360°/n mit n gleich einer natürlichen Zahl und n > 4 erfolgen. Die obigen Gleichungen können dann durch die entsprechenden zu n passenden Gleichungen ersetzt werden.

**Patentansprüche**

1. Verfahren zum Messen zumindest einer Eigenschaft einer Spule, vorzugsweise einer bei Messungen anderer Größen eingesetzten Messspule, wobei die Spule modelliert wird und ein Strom - Spannungswandler (R_FP) in Reihe geschaltet wird, und wobei

   a) die Spule mit einer eine erste Frequenz aufweisenden Wechselspannung mit von Null verschiedenem Gleichspannungsanteil beaufschlagt wird und die Spannung am Strom - Spannungswandler (R_FP) mit einer zweiten Frequenz erfasst wird, die ein Vielfaches der ersten Frequenz ist, wobei das Vielfache als n-faches mit n einer natürlichen Zahl zumindest das Vierfache ist und aus mindestens n in Folge so erfassten Messwerten die Impedanz und der Phasenwinkel bei der ersten Frequenz abgeleitet werden,
   **dadurch gekennzeichnet, dass**

b) die Spule mit einer eine von der ersten Frequenz verschiedene dritte Frequenz aufweisenden Wechselspannung mit von Null verschiedenem Gleichspannungsanteil beaufschlagt wird und die Spannung am Strom - Spannungswandler mit der zweiten Frequenz oder einer vierten Frequenz erfasst wird, die ein Vielfaches der dritten Frequenz ist, wobei das Vielfache als m-faches mit einer natürlichen Zahl zumindest das Vierfache ist und aus mindestens m in Folge so erfassten Messwerten die Impedanz und der Phasenwinkel bei der dritten Frequenz abgeleitet werden,

dass die Spule als Parallelschaltung erstens einer Kapazität (Cp) mit zweitens einer Reihenschaltung aus einem Gleichspannungswiderstand (Rdc), einem frequenzabhängigen Widerstand (Rs) und einer Induktivität (Ls) modelliert wird,

und dass aus den beiden Impedanzen und den beiden Phasenwinkeln der Wert für den Gleichspannungswiderstand (Rdc), den frequenzabhängigen Widerstand (Rs) und/oder die Induktivität (Ls) abgeleitet werden.

2. Verfahren nach Anspruch 1,
**dadurch gekennzeichnet, dass**
die Wechselspannung in Schritt a) und b) jeweils eine sinusförmige Spannung ist, wobei sich die Spannungen in ihrer Frequenz voneinander unterscheiden.

3. Verfahren nach Anspruch 2,
**dadurch gekennzeichnet, dass**
im Schritt b) die dritte Frequenz das Dreifache der ersten Frequenz in Schritt a) beträgt.

4. Verfahren nach einem der vorhergehenden Ansprüche,
**dadurch gekennzeichnet, dass**
in Schritt a) und b) jeweils dieselbe Rechteckspannung erzeugt wird, die in Schritt a) und b) durch unterschiedliche Filter geleitet wird.

5. Verfahren nach einem der vorhergehenden Ansprüche,
**dadurch gekennzeichnet, dass**
das Erfassen der Spannung am Strom - Spannungs - Wandler (R_FP) phasensynchron mit der beaufschlagten Wechselspannung und vorzugsweise bei einer Phase von 0°, 90°, 180° und 270° erfolgt.

6. Vorrichtung zum Messen zumindest einer Eigenschaft einer Spule, insbesondere mit einem Verfahren nach einem der Ansprüche 1 bis 5, mit einem Strom - Spannungswandler, vorzugsweise einem zur Reihenschaltung mit der Spule vorgesehenen Messwiderstand (R_FP), mit einem Generator für eine Eingangs - Wechselspannung, die einen Gleichspannungsanteil aufweist, mit einer Abtastschaltung für das Ausgangssignal des Strom - Spannungswandlers, die ein zur Eingangs - Wechselspannung phasensynchrones Abtasten mit einem Mehrfachen der Frequenz der Eingangs - Wechselspannung bewirkt, wobei das Mehrfache zumindest das Vierfache ist und mit einer Auswerteeinrichtung, der die von der Abtastschaltung abgetasteten Messwerte zugeführt werden,
**dadurch gekennzeichnet, dass**
die Vorrichtung einen Frequenzwandler umfasst und die Auswerteeinrichtung unter Modellierung der Spule als Parallelschaltung erstens einer Kapazität (Cp) mit zweitens einer Reihenschaltung aus einem Gleichspannungswiderstand (Rdc), einem frequenzabhängigen Widerstand (Rs) und einer Induktivität (Ls) den Wert für den Gleichspannungswiderstand (Rdc), für den frequenzabhängigen Widerstand (Rs) und/oder die Induktivität (Ls) berechnet.

7. Vorrichtung nach Anspruch 6,
**dadurch gekennzeichnet, dass**
der Frequenzwandler ein Frequenzteiler ist, der optional einschaltbar ist.

8. Vorrichtung nach Anspruch 6 oder 7,
**dadurch gekennzeichnet, dass**
die Abtastschaltung hinter dem Ausgang des Frequenzwandlers und hinter dem Ausgang des Strom - Spannungswandlers jeweils einen Tiefpassfilter beinhaltet und die Ausgänge beider Tiefpassfilter einem Multiplexer zugeführt werden, dessen Ausgang einem Analog - Digital - Wandler zugeführt wird, dessen Ausgang seinerseits einem Mikroprozessor als Auswerteeinrichtung zugeführt wird.

9. Vorrichtung nach Anspruch 6 oder 7,
**dadurch gekennzeichnet, dass**
die Abtastschaltung das Ausgangssignal des Frequenzwandlers und des Strom - Spannungswandlers zusammen einem Multiplexer zuführt, dessen Ausgangssignal erstens einen Tiefpassfilter durchläuft, dessen Ausgang einem ersten Analog - Digital - Wandler zugeführt wird, dessen Ausgang seinerseits einem Mikroprozessor als Auswerteeinrichtung zugeführt wird, wobei das Ausgangssignal des Multiplexers zweitens einem Bandpassfilter zugeführt wird, dessen Ausgangssignal dem ersten oder einem zweiten Analog - Digital - Wandler zugeführt wird, dessen Ausgangssignal seinerseits dem Mikroprozessor zugeführt wird.

**Claims**

1.  A method for measuring at least one property of a coil, preferably a measuring coil used in measurements of other variables, wherein the coil is modelled and a current-voltage converter (R_FP) is connected in series, and wherein

    a) an AC voltage having a first frequency and having a DC voltage component which differs from zero is applied to the coil, and the voltage at the current-voltage converter (R_FP) is captured at a second frequency which is a multiple of the first frequency, wherein the multiple, as an n-tuple where n is a natural number, is at least four, and the impedance and the phase angle at the first frequency are derived from at least n measured values captured in succession in this manner,
    **characterised in that**
    b) an AC voltage having a third frequency which differs from the first frequency and having a DC voltage component which differs from zero is applied to the coil, and the voltage at the current-voltage converter is captured at the second frequency or at a fourth frequency which is a multiple of the third frequency, wherein the multiple, as an m-tuple with a natural number, is at least four, and the impedance and the phase angle at the third frequency are derived from at least m measured values captured in succession in this manner,
    the coil is modelled as a parallel circuit, firstly with a capacitance (Cp), with secondly a series circuit, a DC voltage resistance (Rdc), a frequency-dependent resistance (Rs) and an inductance (Ls),
    and the value for the DC voltage resistance (Rdc), the frequency-dependent resistance (Rs) and/or the inductance (Ls) are derived from the two impedances and the two phase angles.

2.  The method according to claim 1,
    **characterised in that**
    the AC voltage in steps a) and b) is a sinusoidal voltage in each case, wherein the voltages differ from one another in terms of their frequency.

3.  The method according to claim 2,
    **characterised in that**
    in step b), the third frequency is three times the first frequency in step a).

4.  The method according to one of the preceding claims, **characterised in that**
    the same square-wave voltage is generated in each case in steps a) and b) and is passed through different filters in steps a) and b).

5.  The method according to one of the preceding claims, **characterised in that**
    the voltage at the current-voltage converter (R_FP) is captured in phase with the applied AC voltage and preferably at a phase of 0°, 90°, 180° and 270°.

6.  A device for measuring at least one property of a coil, in particular using a method according to one of claims 1 to 5, having a current-voltage converter, preferably a measuring resistor (R_FP) provided for series connection with the coil, having a generator for an input AC voltage, which has a DC portion, having a sampling circuit for the output signal of the current-voltage converter, which causes a sampling, in phase with the input AC, with a multiple of the frequency of the input AC, wherein the multiple is at least four, and having an evaluation means, to which the measured values sampled by the sampling circuit are supplied,
    **characterised in that**
    the device comprises a frequency converter and the evaluation means, with modelling of the coil as a parallel circuit firstly with a capacitance (Cp), with secondly a series circuit, calculates the value for the DC voltage resistance (Rdc), for the frequency-dependent resistance (Rs) and/or the inductance (Ls).

7.  The device according to claim 6,
    **characterised in that**

the frequency converter is a frequency divider which can be optionally switched on.

8. The device according to claim 6 or 7,
**characterised in that**
the sampling circuit includes a respective low-pass filter downstream of the output of the frequency converter and downstream of the output of the current-voltage converter, and the outputs of both low-pass filters are supplied to a multiplexer, the output of which is supplied to an analog/digital converter, the output of which is in turn supplied to a microprocessor as an evaluation means.

9. The device according to claim 6 or 7,
**characterised in that**
the sampling circuit jointly supplies the output signal from the frequency converter and from the current-voltage converter to a multiplexer, the output signal of which first of all passes through a low-pass filter, the output of which is supplied to a first analog/digital converter, the output of which is in turn supplied to a microprocessor as an evaluation means, wherein the output signal of the multiplexer is secondly supplied to a bandpass filter, the output signal of which is supplied to the first or a second analog/digital converter, the output signal of which is in turn supplied to the microprocessor.


**Revendications**

1. Procédé de mesure d'au moins une propriété d'une bobine, de préférence d'une bobine de mesure utilisée pour des mesures d'autres grandeurs, dans lequel on modélise la bobine et on monte en série un transducteur (R_FP) de courant-tension, et dans lequel

   a) on applique à la bobine une tension alternative ayant une première fréquence et ayant une proportion de tension continue différente de zéro et
   on détecte la tension au transducteur (R_FP) de courant-tension à une deuxième fréquence, qui est un multiple de la première fréquence, dans lequel le multiple est au moins le quadruple sous la forme de n fois, n étant un entier naturel, et on déduit d'au moins n valeurs de mesure ainsi détectées à la suite l'impédance et l'angle de phase à la première fréquence, **caractérisé en ce que**
   b) on applique à la bobine une troisième tension alternative ayant une fréquence différente de la première fréquence et ayant une proportion de tension continue différente de zéro et on détecte la tension au transducteur de courant-tension à la deuxième fréquence ou une quatrième fréquence, qui est un multiple de la troisième fréquence, le multiple étant au moins le quadruple sous la forme de m fois, m étant un entier naturel, et on déduit l'impédance et l'angle de phase à la troisième fréquence d'au moins m valeurs de mesure ainsi détectées à la suite,
   **en ce que** l'on modélise la bobine sous la forme d'un circuit parallèle premièrement d'une capacité (Cp) et deuxièmement d'un circuit série composé d'une résistance (Rdc) en tension continue, d'une résistance (Rs) en fonction de la fréquence et d'une inductance (Ls),
   et **en ce que** l'on déduit, à partir des deux impédances et des deux angles de phase, la valeur de la résistance (Rdc) en tension continue, de la résistance (Rs) en fonction de la fréquence et/ou de l'inductance (Ls).

2. Procédé suivant la revendication 1,
**caractérisé en ce que**
la tension alternative aux stades a) et b) est respectivement une tension sinusoïdale, les tensions différant l'une de l'autre par leur fréquence.

3. Procédé suivant la revendication 2,
**caractérisé en ce que**
au stade b) la troisième fréquence représente le triple de la première fréquence au stade a).

4. Procédé suivant l'une des revendications précédentes, **caractérisé en ce que**
l'on produit aux stades a) et b) respectivement la même tension rectangulaire, que l'on fait filtre aux stades a) et b) dans des filtres différents.

5. Procédé suivant l'une des revendications précédentes, **caractérisé en ce que**
la détection de la tension au transducteur (R_FP) de courant-tension s'effectue de manière synchrone en phase avec la tension alternative appliquée et de préférence à une phase de 0°, 90°, 180° et 270°.

**6.** Montage de mesure d'au moins une propriété d'une bobine, notamment par un procédé suivant l'une des revendications 1 à 5, comprenant un transducteur de courant-tension, de préférence une résistance (R_FP) de mesure, prévue suivant un circuit série avec la bobine, comprenant un générateur d'une tension alternative d'entrée, qui a une proportion de tension continue, comprenant un circuit de détection du signal de sortie du transducteur de courant-tension, qui provoque une détection de manière synchrone en phase avec la tension alternative d'entrée à un multiple de la fréquence de la tension alternative d'entrée, le multiple étant au moins le quadruple et comprenant un dispositif d'exploitation, auquel les valeurs de mesure détectées par le circuit de détection sont envoyées, **caractérisé en ce que**
le montage comprend un convertisseur de fréquence et le dispositif d'exploitation calcule, en modélisant la bobine sous la forme d'un circuit parallèle, premièrement d'une capacité (Cp) et deuxièmement d'un circuit série composé d'une résistance (Rdc) en tension continue, d'une résistance (Rs) en fonction de la fréquence et d'une inductance (Ls), la valeur de la résistance (Rdc) de tension continue, de la résistance (Rs) en fonction de la fréquence et/ou de l'inductance (Ls).

**7.** Montage suivant la revendication 6,
**caractérisé en ce que**
le convertisseur de fréquence est un diviseur de fréquence, qui peut être mis en circuit facultativement.

**8.** Montage suivant la revendication 6 ou 7,
**caractérisé en ce que**
le circuit de détection comporte, derrière la sortie du convertisseur de fréquence et derrière la sortie du transducteur de courant-tension, respectivement un filtre passe-bas et les sorties des deux filtres passe-bas sont envoyées à un multiplexeur, dont la sortie est envoyée à un convertisseur analogique-numérique dont la sortie est envoyée pour sa part à un microprocesseur comme dispositif d'exploitation.

**9.** Montage suivant la revendication 6 ou 7,
**caractérisée en ce que**
le circuit de détection envoie le signal de sortie du convertisseur de fréquence et du transducteur de courant-tension ensemble à un multiplexeur, dont le signal de sortie passe premièrement dans un filtre passe-bas, dont la sortie est envoyée à un premier convertisseur analogique-numérique, dont la sortie est envoyée pour sa part à un microprocesseur comme dispositif d'exploitation, dans lequel le signal de sortie du multiplexeur est envoyé deuxièmement à un filtre passe-bande, dont le signal de sortie est envoyé au premier ou à un deuxième convertisseur analogique-numérique, dont le signal de sortie est envoyé pour sa part au microprocesseur.

**Fig. 1**

**Fig. 2**

u

Ls

Rs

i

**Fig. 3A**

u Ls

u

u Rs

iLs

u

φ

i

**Fig. 3B**

u

Ls

Rs

I/U
Wandler

u_IU

**Fig. 4A**

u

φ

u_IU

**Fig. 4B**

**Fig. 5A**

**Fig. 5B**

f_gen = f_Mess x 2

**Fig. 6**

**Fig. 7A**

**Fig. 7B**

**Fig. 7C**

Fig. 8

EP 3 420 369 B1

**Fig. 9**

**Fig. 12**

**Fig. 10A**

EP 3 420 369 B1

EP 3 420 369 B1

GEN

42

Tiefpass

FP

44

Tiefpass

46
MUX

48
ADC

50
Winkel
0°
90°
180°
270°

52
Filter

54
Berechnung

Rdc

Rs

Ls

**Fig. 10B**

**Fig. 11A**

EP 3 420 369 B1

Fig. 11B

**Fig. 13**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6469500 B1
- US 7053603 B2
- DE 102010036126 B3
- FR 2565695 A1
- US 4103233 A
- DE 102008042095 A1